Europäisches Patentamt

European Patent Office

Office européen des brevets

(11) Publication number: **0 153 092**
**A2**

(19)

# (12) EUROPEAN PATENT APPLICATION

(21) Application number: 85300808.4

(51) Int. Cl.⁴: **H 03 H 9/64**

(22) Date of filing: 07.02.85

(30) Priority: 15.02.84 US 580418

(43) Date of publication of application: 28.08.85
Bulletin 85/35

(84) Designated Contracting States: **DE FR GB IT**

(71) Applicant: **TRW INC., 23555 Euclid Avenue, Cleveland Ohio 44117 (US)**

(72) Inventor: **Stokes, Robert Bruce, 4230 W. 180th Street, Torrance California 90504 (US)**
Inventor: **Yen, Kuo-Hsiung, 1521-23rd Street, Manhattan Beach California 90266 (US)**
Inventor: **Lau, Kei Fung, 23505 Himber Place, Harbor City California 90710 (US)**
Inventor: **Kagiwada, Reynold Shigeru, 3117 Malcolm Avenue, Los Angeles California 90034 (US)**

(74) Representative: **Allden, Thomas Stanley et al, A.A. THORNTON & CO. Northumberland House 303-306 High Holborn, London WC1V 7LE (GB)**

(54) **Surface acoustic wave bandpass filter.**

(57) A surface acoustic wave (SAW) bandpass filter having improved out-of-band rejection and minimization of problems arising from bulk waves, diffraction and other effects. The filter comprises a phased array of input transducers disposed on a substrate to act in the manner of a diffraction-effect device, and a single interdigital output transducer positioned to receive acoustic energy only in a selected band of frequencies transmitted by the input array. The input array is preferably amplitude-weighted in accordance with a combination of techniques, includes width aperture weighting, resistive weighting, capacitive weighting, serial-parallel transducer connections, and source withdrawal.

-1-

# SURFACE ACOUSTIC WAVE BANDPASS FILTER

## BACKGROUND OF THE INVENTION

This invention relates generally to surface acoustic wave (SAW) devices, and more particularly, to bandpass filters implemented in SAW technology. By way of brief background, SAW devices employ substrates of a piezoelectric material, across which elastic surface waves are propagated between sets of electro-acoustic transducers disposed on the substrate surface. The devices employ so-called Rayleigh waves, which can be propagated along a free surface of a solid, and have an amplitude of displacement that is largest right at the substrate surface. In a piezoelectric material, deformations produced by such waves induce local electric fields, which are propagated with the acoustic waves and extend into space above the surface of the material. These electric fields will interact with electrodes disposed on the surface of the material, which serve as electrical input and output transducers for the surface acoustic wave device.

SAW bandpass filters usually include one input transducer and one output transducer, both of the interdigital type with straight fingers. The transducers are placed in alignment with the principal propagation axis of the substrate. The sidelobe rejection associated with such in-line filters is typically no more than 60 dB. Conventional in-line filters also suffer from effects of diffraction, feed-through, and wavefront distortion due to linewidth variations in the device. The reason for this is that spurious bulk waves can also be efficiently excited by the input transducer and detected by the output transducer. Various techniques have been developed to eliminate the spurious bulk waves. Some of these approaches involve the incorporation of a multistrip coupler, or the use of a tapered substrate or a roughened substrate surface on the underside. However, a multistrip coupler is suitable for use in only highly piezoelectric substrates, and is very lossy at frequencies over 500 MHz. The use of tapered or roughened substrates requires additional processing and is not suitable for thin substrates. In brief, there is no wholly satisfactory technique for constructing an in-line SAW bandpass filter.

Although most SAW devices are "in-line" devices employing a single propagation direction, SAW technology can also be applied to diffraction-effect devices, such as spectrum analyzers. A SAW spectrum analyzer is disclosed in a copending application of Robert E. Brooks, Serial No. 529,066, filed on September 2, 1983, and entitled "Signal Processing System and Method." The Brooks application describes the basis on which a SAW spectrum analyzer operates. In essence, the principle of operation is closely analogous to that of an optical diffraction grating. When a collimated beam of light is incident on a plane grating, the scattered light is dispersed into monochromatic waves propagating at angles dependent on their wavelength. If the scattered waves are imaged to points or lines by a focusing lens, a number of diffraction orders will be seen. In each order except the zero order, the light is dispersed into its spectral components. This basic property is used in the optical spectrograph, in which the grating is curved to eliminate the need for a focusing lens, and is "blazed" to provide a multiplicity of flat reflective scattering strips. By this means, the grating scatters light only in a single diffraction order, and no energy is lost to the unused orders.

The SAW counterpart of the optical spectrograph is closely analagous to a curved and blazed diffraction grating. As in the optical spectrograph, the device is constructed so that almost all of the energy is confined to the first order. Basically, the SAW device comprises a curved input transducer array having a large number of wideband interdigital transducers connected in parallel, and an array of output transducers. Each input transducer is so small that it behaves very much like a point source of energy, which can be considered to radiate circular wavefronts if the anisotropic nature of most SAW substrate materials is neglected.

The curvature of the input transducer array causes the energy from the array to focus at a focal point located at a predetermined focal distance from the array. At the focal point, wavefronts from all of the input transducers arrive simultaneously and reinforce each other. The zero-order focal point is, therefore, at the center of curvature of the array, and each wavefront arriving at the focal point has traversed the same distance from an input transducer. A first-order focal point is laterally spaced from the zero-order focal point. Waves from two adjacent transducers still arrive at the first-order focal point

-4-

in phase with each other, but their path lengths differ by one wavelength, or some other integral number of wavelengths. Now if the frequency of the signal applied to the input array is changed, the first-order focal point is shifted laterally with respect to the zero-order focal point. If a wideband input signal is applied to the input array, the first-order focal point becomes a focal arc, each point on the arc representing a different input frequency. The output transducers are arrayed along the focal arc, to provide a set of output signals that are representative of a frequency spectrum. This, then, is the basis for spectral analysis using SAW techniques.

Although the aforementioned copending application disclosed a device of this kind that is generally satisfactory in most respects as a spectral analyzer, two-dimensional or diffraction-effect SAW techniques have not been previously applied to the construction of bandpass filters. Accordingly, there is still a need for bandpass filter that effectively suppresses or minimizes the effect of bulk waves without the difficulties usually associated with this task. The present invention fulfills this need.

## SUMMARY OF THE INVENTION

The present invention resides in a SAW bandpass filter having a phased input array, like the input array of a SAW spectrum analyzer, and a single output transducer positioned at a desired frequency-dependent location on a first-order focal arc associated with the input array. In addition to utilizing the spatial dispersion of the SAW device, both the input and output transducers may be made more frequency selective, by conventional techniques, to further improve the filter characteristics. Further improvement results from the amplitude weighting of the input transducer array, to suppress spatial sidelobes in the focused beam.

More specifically, the input transducer array is amplitude-weighted to improve beam focusing and reduce beam sidelobes, by means of one or more of a number of disclosed techniques. In one technique, the input tranducer array is amplitude-weighted by means of series capacitance coupling of the input signals to selected ones of the input transducers. In another disclosed approach, amplitude weighting is effected by selectively coupling the input transducers in series and parallel relationships to vary the amplitude of the resultant acoustic radiation across the array.

Yet another approach is to effect amplitude weighting by selective removal of some of the input tranducers from the array. Overlap weighting, wherein the degree of overlap of the fingers in a transducer is selectively varied to control the amplitude of the generated acoustic signal, may be usefully combined with one of the foregoing coarser techniquies, such as selective series-parallel connection or transducer source withdrawal. Finally, any of the aforementioned techniques may be usefully combined with resistive weighting, wherein selected ones of the input transducers have the input signals coupled to them through series resistors.

It will be appreciated from the foregoing that the present invention represents a significant advance in the field of SAW bandpass filters. In particular, the improvements of the invention result in an improved frequency characteristic of the filter and minimization of the effects of unwanted bulk waves. Other aspects and advantages of the invention will

-6-

become apparent from the following more detailed description, taken in conjunction with the accompanying drawings.

## BRIEF DESCRIPTION OF THE DRAWINGS

FIGURE 1 is a diagrammatic representation, in plan view, of a SAW bandpass filter in accordance with the invention;

FIG. 2 is a fragmentary plan view of an input transducer array that is amplitude weighted by aperture width weighting;

FIG. 3 is a fragmentary plan view of an input transducer array that is amplitude weighted by capacitive weighting;

FIG. 4 is a fragmentary plan view of an input transducer array that is amplitude weighted by resistive weighting;

FIG. 5 is a fragmentary plan view of an input transducer array whose elements are connected selectively in series and parallel for amplitude weighting;

FIG. 6 is a fragmentary plan view of an input transducer array employing source withdrawal for amplitude weighting;

FIG. 7 is a graph showing the frequency response of a SAW bandpass filter in accordance with the invention.

## DESCRIPTION OF THE PREFERRED EMBODIMENTS

As shown in the drawings for purposes of illustration, the present invention is concerned with surface acoustice wave (SAW) devices of the type that are used as bandpass filters. In accordance with the invention, a SAW bandpass filter includes a phased array of input tranducers, indicated generally by reference numeral 20, and a single interdigital output transducer 22, both input and output transducers being disposed on the surface of a piezoelectric substrate 24. An electrical input signal, typically having a wide band of frequency components is applied to the input transducer array 20, and the device functions to provide a selected band of output signals from the output transducer 22.

The principle of operation of the phased input array 20 is analagous to that of an optical diffraction grating. The input transducer array includes a relatively large number of individual transducers, each of which, at least in theory, functions as a point source of acoustic energy. If the substrate material is isotropic, the point sources of radiation give rise to circular wavefronts emanating from each input transducer. In practice, many SAW substrates are anisotropic, and the wavefront velocity is dependent on the direction of propagation.

The transducers in the input array 20 are positioned on a circular arc, and the separate wavefronts from all of the transducers will reinforce each other at a zero-order focal point, indicated at 26, which is equidistant from all of the transducers. The zero-order focal point will be the same regardless of the frequency of the signals. As in the optical analogy, there are other "diffraction" orders in the SAW device. For any given frequency, there is a first-order focal point, such as is shown at 28, where the acoustic waves from all of the input tranducers also combine to reinforce each other, but there is a one-wavelength difference in the path lengths to the focal point from any two adjacent transducers. As the frequency of the input signals changes, the position of this first-order focal point shifts laterally along a focal arc, indicated at 30.

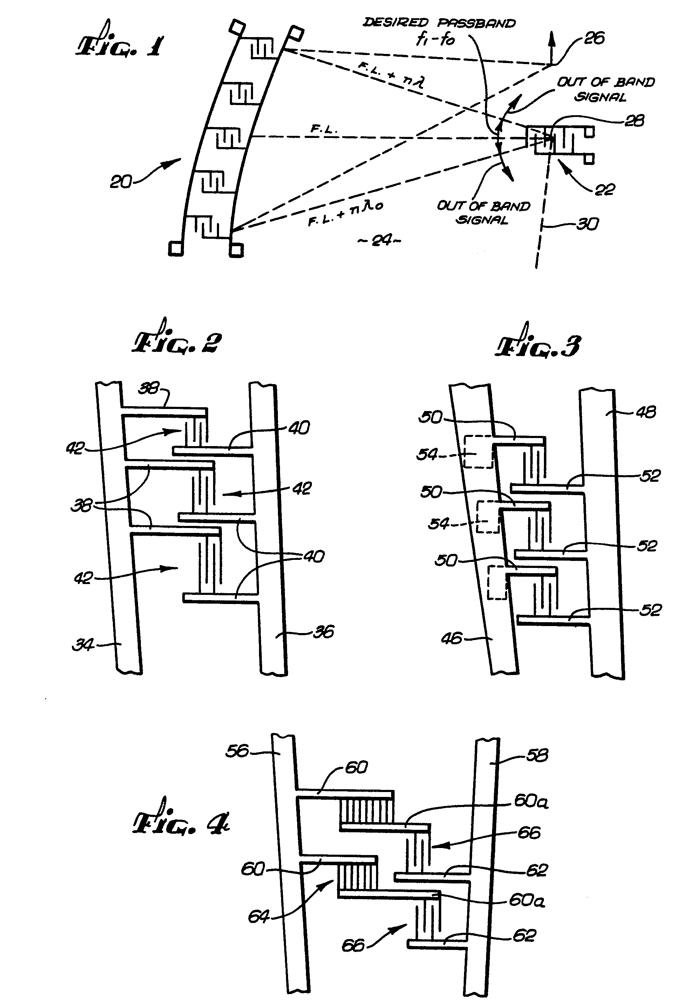

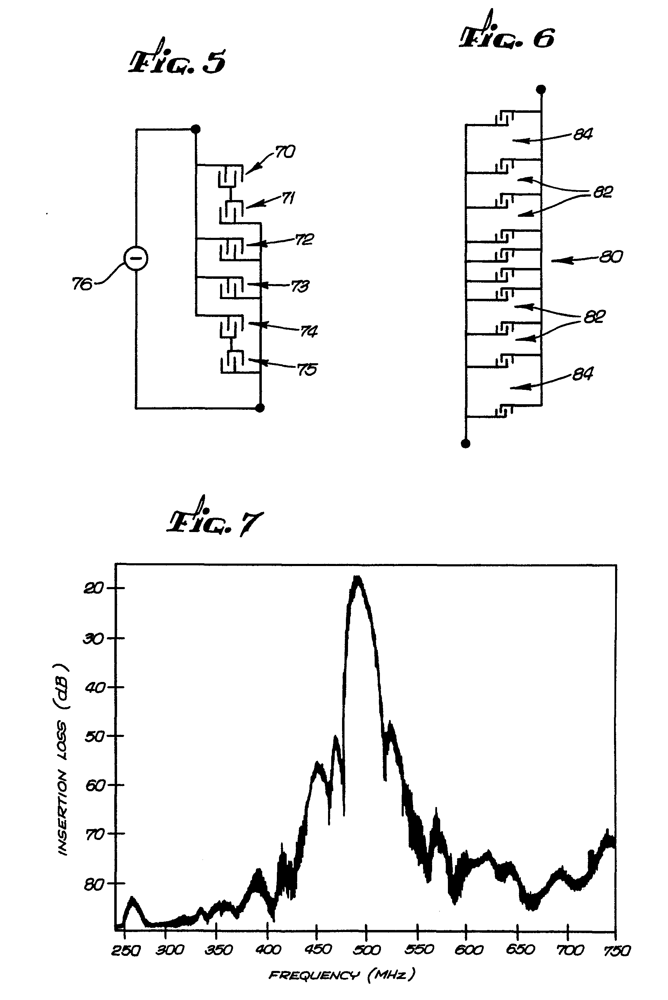

The output transducer 22 is positioned at a point on the focal arc 30 corresponding to the center frequency of the bandpass filter. The device as described may be further improved by the use of amplitude weighting in the input transducer array, as will now be described in more detail with reference to FIGS. 2-6. FIG. 2 shows how the input transducer array 20 is amplitude-weighted by varying the width of each transducer. The transducer structure illustrated includes two electrodes 34 and 36 arranged in an approximately parallel relationship and having sum bars 38 and 40 extending toward each other in an overlapping relationship, referred to as an interdigital relationship. Extending from each of the sum bars are transducer elements or fingers 42. These are also arranged in an interdigital relationship. Each interdigital set of fingers 42 constitutes a transducer cell, and it will be seen that the three cells shown have different apertures or widths, i.e. the transducer fingers overlap by different amounts. This provides a continuously variable control over the transducer cell amplitude, so that the array 20 may be amplitude weighted in any desired manner to minimize sidelobes from the acoustic beam emanating from the array.

FIG. 3 shows another type of amplitude weighting, employing series capacitance elements. By way of example, two electrodes 46 and 48 are shown as substantially parallel. As in the previously described array, each electrode has sum bars 50 and 52 that are interdigital in form, but the sum bars 50 do not connect directly with the main electrode 46. Instead, they terminate in enlarged pads 54 beneath the electrode 46, and are separated therefrom by a dielectric layer, such as silicon dioxide ($SiO_2$), which is not shown in FIG. 3. Thus, each of the sum bars 50 includes a seriesconnected capacitance, formed by one of the pads 54 and the electrode 46. This form of amplitude weighting is, however, not suitable for higher frequencies of operation.

FIG. 4 illustrates a form of resistive weighting for the same general purpose. Again, there are two substantially parallel electrodes 56 and 58, each of which has sum bars 60 and 62. However, the sum bars 60 do not overlap the sum bars 62. Instead, they overlap subsidiary sum bars 60a, which are joined to the main sum bars 60 by relatively thin conductive strips 64. The subsidiary sum bars 60a overlap the opposing sum bars 62, and there are interdigital fingers 66 extending from both the sum bars 62 and the subsidiary sum bars 60a. The conductive strips 64 are used as adjustable resistive elements, and may be trimmed by laser or other methods, for any needed fine-tuning prior to completion of the fabrication process.

FIG. 5 shows another technique for amplitude weighting of the input transducer array 20. Six transducer cells 70-75 are shown by way of example, connected to an input signal source 76. Transducers that are the first two in the array, i.e. those referred to by numerals 70 and 71, are connected in series with the signal source 76. Likewise, the last two transducers 74 and 75 in the array are also connected in series. The two transducers 72 and 73 in the middle of the array are connected in parallel directly to the signal source 76. This provides a coarse form of amplitude weighting, since it will be seen that the amplitude resulting from the middle transducers 72 and 73 will be twice that of the outer transducers 70, 71, 74 and 75.

Another coarse form of amplitude weighting is shown in FIG. 6. Basically, transducers near the center of the array 20 are closely spaced as usual, as indicated at 80, but are spaced less closely as the ends of the array are approached. Numeral 82 indicates spaces in the array that would normally accommodate one additional transducer, and numeral 84 indicates spaces that would normally accommodate two additional transducers. In practice, these last-described coarse weighting techniques can be best applied in combination with another approach, such as aperture width weighting, for fine-tuning the array to provide a desired output pattern.

As shown in FIG. 7, the improved bandpass filter of the invention has good frequency characteristics even when the transducers are not designed to be frequency selective. With appropriate frequency-selective tranducers, the device can achieve up to 90 dB out-of-band rejection.

It will be appreciated from the foregoing that the present invention represents a significant advance in the field of surface acoustic wave devices. In particular, the invention provides improved performance in a SAW bandpass filter. The new filter has improved sidelobe rejection and practically eliminates problems due to bulk waves, and other effects such as diffraction, feedthrough and wavefront distortion. It will also be appreciated that, although the preferred embodiment of the invention has been described in detail for purposes of illustration, various modifications may be made without departing from the spirit and scope of the invention. Accordingly, the invention is not to be limited except as by the appended claims.

CLAIMS:

1. A surface acoustic wave (SAW) bandpass filter, comprising:

a piezoelectric substrate;

an input transducer array disposed on the surface of said substrate, said array having a plurality of individual interdigital transducers spaced along a curve and connected electrically for the application of input signals, to provide acoustical radiation that is focused along a focal arc, each position on the focal arc being representative of a different frequency component in the input signals; and

an output transducer disposed on said substrate in a selected position in the focal arc, to receive a selected band of frequency signals and convert them to corresponding elelctrical output signals.

2. A surface acoustic wave bandpass filter as set forth in claim 1, wherein:

said input transducer array is amplitude-weighted to improve beam focusing and reduce beam sidelobes, and wherein said input transducer array is amplitude-weighted by means including means for selectively coupling said input transducers in series and parallel relationships to vary the amplitude of the resultant acoustic radiation across the array.

3. A surface acoustic wave bandpass filter as set forth in claim 1, wherein:

said input transducer array is amplitude-weighted to improve beam focusing and reduce beam sidelobes, and wherein said input transducer is amplitude-weighted by selective removal of some of said input tranducers from the array.

4.  A surface acoustic wave bandpass filter as set forth claim 2, wherein:
said input transducer array is also amplitude-weighted by means of overlap weighting, wherein the degree of overlap of transducer fingers is selectively varied across the array.

5.  A surface acoustic wave bandpass filter as set forth in claim 3, wherein:
said input transducer array is also amplitude-weighted by means of overlap weighting, wherein the degree of overlap of transducer fingers is selectively varied across the array.

6.  A surface acoustic wave bandpass filter as set forth in claim 2, wherein:
said input transducer array is also amplitude-weighted by means of resistive weighting, wherein selected ones of said input transducers have the input signals coupled to them through series resistors.

7.  A surface acoustic wave bandpass filter as set forth in claim 3, wherein:
said input transducer array is also amplitude-weighted by means of resistive weighting, wherein selected ones of said input transducers have the input signals coupled to them through series resistors.

8.  A surface acoustic wave bandpass filter as set forth in claim 4, wherein:

-13-

said input transducer array is also amplitude-weighted by means of resistive weighting, wherein selected ones of said input transducers have the input signals coupled to them through series resistors.

9. A surface acoustic wave bandpass filter as set forth in claim 5, wherein:
said input transducer array is also amplitude-weighted by means of resistive weighting, wherein selected ones of said input transducers have the input signals coupled to them through series resistors.

**Fig. 1**

DESIRED PASSBAND
$f_1 - f_0$

26

F.L. + $n\lambda$

OUT OF BAND SIGNAL

28

F.L.

20

F.L. + $n\lambda o$

22

OUT OF BAND SIGNAL

30

~24~

**Fig. 2**

38
40
42
38
42
40
42
34
36

**Fig. 3**

50
54
50
54
50
48
52
52
52
46

**Fig. 4**

56
60
58
60a
66
60
62
60a
64
66
62

0153092

2/2

**Fig. 5**

**Fig. 6**

**Fig. 7**

INSERTION LOSS (dB) vs FREQUENCY (MHz)